**Europäisches Patentamt**

**European Patent Office**

**Office européen des brevets**

(19)

(11) Publication number: **0 007 127**
**B1**

(12) **EUROPEAN PATENT SPECIFICATION**

(45) Date of publication of patent specification: **29.12.82**

(21) Application number: **79200344.4**

(22) Date of filing: **27.06.79**

(51) Int. Cl.³: **G 03 F 7/24, G 03 F 7/18**

(54) Process and apparatus for the manufacture of a relief printing form.

(30) Priority: **10.07.78 NL 7807399**

(43) Date of publication of application:
**23.01.80 Bulletin 80/2**

(45) Publication of the grant of the patent:
**29.12.82 Bulletin 82/52**

(84) Designated Contracting States:
**AT BE CH DE FR GB IT LU NL SE**

(56) References cited:
**DE - A - 1 522 508**
**DE - A - 2 603 082**
**JP - B - 43 070 274**
**NL - A - 293 091**
**NL - A - 6 506 698**
**NL - A - 7 213 421**
**NL - A - 7 504 012**
**US - A - 3 294 889**
**US - A - 3 496 606**
**US - A - 3 615 470**

(73) Proprietor: **Akzo N.V.**
**Velperweg 76**
**NL-6824 BM Arnhem (NL)**

(72) Inventor: **Schoute, Johannes Cornelis**
**Byvang 8**
**4623 AM Bergen op Zoom (NL)**

(74) Representative: **Sieders, René et al,**
**P.O. Box 314**
**NL-6800 AH Arnhem (NL)**

Courier Press, Leamington Spa, England.

## Process and apparatus for the manufacture of a relief printing form.

The invention relates to a process and apparatus for the manufacture of a wholly or partially cylindrical relief printing form from a liquid polymerizable moulding material. A process of the indicated type is, e.g., described in US—A—3283714.

In other known processes of manufacturing cylindrical printing forms from a flexible material, generally first a flat plate is made from a synthetic resin, which plate is hardened in the places corresponding to the printing design by photopolymerization. The resulting flexible flat plate is subsequently curved and mounted on a metal printing cylinder. Although with these known processes reasonable results may be obtained for certain uses, they are found to be less suitable for the manufacture of cylindrical printing forms for printing matter which is to satisfy the present-day high quality demands. The invention has for its object to provide a process of the type mentioned in the opening paragraph by which in an efficient way entirely or partially cylindrical printing forms can be made and by which the present-day high quality demands can be met that are made on flexographic printing matter, more particularly as far as multicolour printing is concerned. In the process according to the invention during rotation the moulding material is spread over the internal surface of a cylindrical wall by centrifugal force and hardened in the desired places by means of ultraviolet rays via an image corresponding to a printing design, after which in the non-hardened places the moulding material is at least partly removed, and as cylindrical wall a transparent, more particularly glass, cylindrical tube is used, against the inside surface of which there is placed an exchangeable image-bearing film having a smooth surface, and the photopolymerizing radiation of the printing form material is effected during rotation of the transparent cylinder by means of radiation sources distributed around the circumference of the transparent cylinder, the rays of which act on the moulding material via the wall of the transparent cylinder and the image-bearing film, and the radiation for hardening the printing form takes plane in an operation following the applying of the moulding material to the cylindrical wall by centrifugal force. For the image generally a photographic negative is used. High operating speed and particularly a satisfactory prepolymerization of the printing form may be obtained if after the moulding material has been applied to the inside of the cylindrical wall by centrifugal force the moulding material is also exposed to radiation from one or more radiation sources on the inside of the rotating cylindrical tube. Favourable results may be obtained by the process according to the invention if the transparent cylinder pervious to UV-radiation is so machined internally that both in radial and in axial direction it does not deviate more than plus or minus 0,10 mm from the desired form of the cylinder relative to the axis of rotation thereof, and preferably not more than plus or minus 0,02 mm. According to a preferred embodiment of the process according to the invention use is made of a transparent cylindrical tube having an inside diameter between 100 mm and 600 mm, a wall thickness of 5 to 20 mm and a length of 200 to 1000 mm. Since in the process according to the invention the moulding material is spread over the wall by centrifugal force, the occlusion of air in the moulding mass will be avoided. The use of a glass cylinder makes it possible to realize such an accuracy as regards the layer thickness as cannot be obtained by some known flat methods. The printing form is made inside a glass cylindrical tube having a radius of curvature which is practically equal to the radius of curvature of the printing form during the flexographic printing process, which leads to the following advantages over the known flat methods:

— No deformation of the image as a result of the printing form being bent whilst mounting it on the printing cylinder.

— Owing to the entire or practically entire absence of internal stresses in the material of the printing form while in its curved state on the printing cylinder in the operating situation the printing form is expected to offer a considerably higher abrasion resistance and also the accuracy of the shape, more particularly the roundness, is favourably influenced.

— The negatives to be used need not be optically corrected to eliminate the effect of deformations, which is often necessary in the case of using the know flat methods for manufacturing printing forms.

— The impression of the printing form always accurately conforming to the negative, better fits can be realized in colour printing.

Generally the advantages to be obtained by the process according to the invention will be greater with increasing thickness of the printing form and with decreasing diameter.

It has been found that the image-bearing film can effectively be placed against the inner wall of the transparent cylinder by applying a vacuum. It is also of advantage to use an image-bearing film which on the side of the glass wall is previously provided with a thin adhesive coating. An effective adhesive coating is of the type which does not become active, i.e. become sticking, until some influence, such as that of surface pressure, heating, radiation, is exerted on the image-bearing film. The image-bearing film can be used several times if prior to the liquid moulding material being introduced the image-bearing film is on the radially inward side provided with a cover film. The invention also comprises an apparatus for carrying out the process according to the invention, which apparatus includes a framework with one or more radiation sources for hardening photopolymerizable moulding material, and a rotatable, transparent, cylindrical forming tube provided according to the invention with a drive, which tube is substantially of glass.

For the process according to the invention the photopolymerizable material may be any UV-curable mixture into which additives may or may not be incorporated. Suitable examples include unsaturated polyester resins and alkyd resins, unsaturated epoxy resins, polybutadiene resins, unsaturated acrylates, unsaturated urethanes, etc., which may or may not contain additives. Alternatively, use may be made of mixtures of unsaturated polymers or UV-curable mixtures of polymers and saturated or unsaturated monomeric compounds. Moreover, the UV-curable moulding material to be used may or may not contain a photoinitiator, which is usually present in an amount of 0,05 to 10 per cent by weight, based on the UV-curable binder. Suitable photoinitiators include aromatic carbonyl compounds such as benzil, benzil dimethyl ketal, acetophenone, substituted acetophenones, thioxanthone and chlorothioxanthone. Also mixtures of photoinitiators may be used.

With the above-mentioned UV-radiation the use is considered of ultraviolet rays in the wave length range of 90 to 600 nanometer.

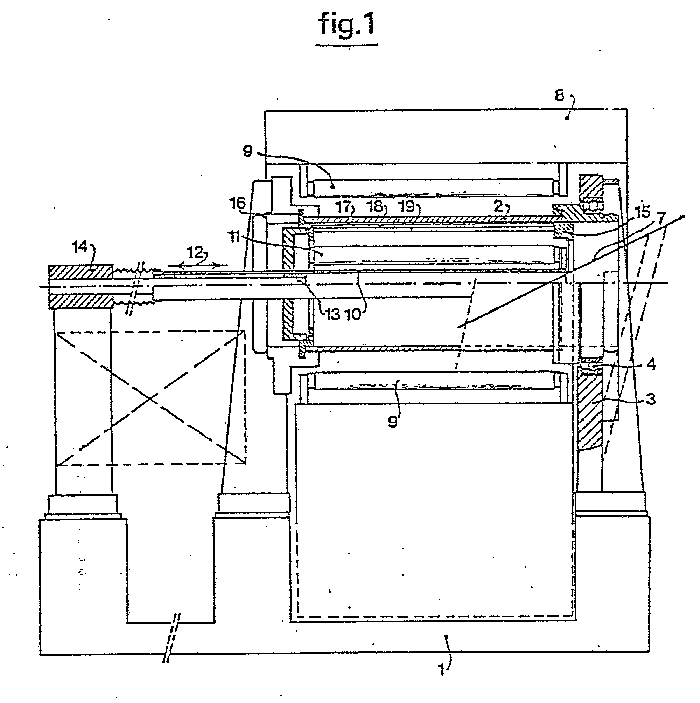

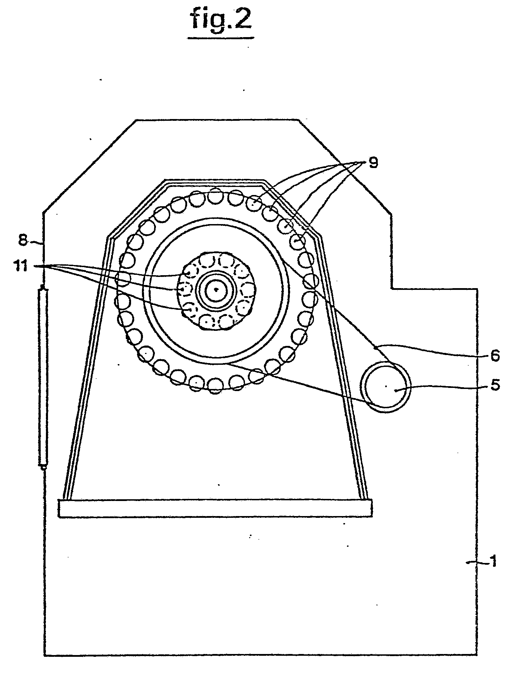

The invention will be further described with reference to the accompanying schematic drawing. Figure 1 is a partial view in longitudinal section of the apparatus according to the invention. Figure 2 is a cross-sectional view of the apparatus shown in Figure 1.

In a framework 1 a transparent circular-cylindrical glass tube 2 is horizontally supported in two upright end pieces 3 by means of bearings 4, which are shown only at one end. The glass tube 2 can be set into rotation by means of a motor 5 having two speeds, e.g. 750 and 1500 revolutions per minute, and a belt transmission 6. Optionally, use may be made of a stepless speed transmission. Mounted on one of the end pieces 3 is a feed trough 7 for introducing the liquid moulding material into the inside of the glass tube 2. Around the glass tube 2 is a bipartite swing-back hood 8 of which in this construction the upper half and the lower half each contain fifteen UV-fluorescent tubes 9. Into the glass tube 2 may be slid a pipe 10. In this construction ten UV-fluorescent tubes 11 are mounted on the pipe 10. The pipe 10 can be axially displaced on a shaft 13 in the directions indicated by an arrow 12 and at the command of control elements not indicated. The shaft 13 is attached to the frame 1 by means of a support 14.

At its two ends the glass tube 2 is provided with annular covers 15 and 16 to keep the liquid moulding material within the glass tube.

Provided on the frame 1, which may be made up of box beams, there are besides the end pieces 3, the hood 8 and the support 14, several switches, pilot lights, etcetera.

In the manufacture of an entirely or partially cylindrical printing form by the process according to the invention first the pipe 10 with UV-tubes 11 is axially moved out of the glass tube 2. Next, an image-bearing film 17 is placed against the inside wall of the glass tube 2, after which a cover film 18 is placed on the image-bearing film 17. Subsequently, the image-bearing film 17 and the cover film 18 are pressed against the cylindrical inner wall of the glass tube 2 while applying a vacuum. If desired, the inner surface of the glass tube 2 may be provided with one or more axial and/or radial grooves for allowing the escape of air, which may be of advantage irrespective of whether or not a vacuum is applied.

After the covers 15 and 16 have been installed, a measured amount of liquid moulding material is poured onto the inner wall of the glass tube 2. After the liquid has been spread over the wall, the rotary speed of the glass tube 2 is increased by changing over to a higher speed. The feed trough 7 has meanwhile been removed from the glass tube 2 and the liquid moulding material has evenly been spread, in the form of for instance a 3 mm thick skin 19, over the cover film 18 within the glass tube 21 under the influence of the centrifugal force. The pipe 10 with UV-fluorescent tubes is now axially slid into the glass tube 2. Subsequently, the UV radiation is switched on, upon which the moulding material 19 is radiated by the internal circle of tubes 11 and the external circle of tubes 9. Radiation of the form skin 19 by the external tubes 11 takes place via the for instance 9 mm thick wall of the glass tube 2, the image-bearing film 17 and the cover film 18. Depending on the pattern or image to be printed the image-bearing film 17 is partly pervious and partly impervious to UV light. In the places where the image-bearing film 17 does allow the passage of light the moulding material is cured as a result of a polymerization process. In the places where the image-bearing film does not allow the passage of UV light the moulding material is not cured or only to a negligible extent. After a few minutes the moulding material has sufficiently hardened in the desired places as a result of prepolymerization. The radiation is now switched off, the rotation of the glass tube 2 is stopped, the internal circle of UV tubes 11 is removed from the glass tube 2 and the covers 15 and 16 are removed.

The prepolymerized skin 19 is now removed from the glass tube 2 and placed on a supporting cylinder which may for instance be of a metal or plastic material. Subsequently, while supplying a washing liquid, the uncured moulding mass is removed from the provisional printing form by brushing or in some other way. Next, the merely prepolymerized printing form is again exposed all around to UV radiation to obtain a sufficiently cured printing form. This post-curing also may be effected by means of electrons or by heat. The resulting printing form may be placed on a matching cylindrical core of the printing machine and is then ready for use in the printing process.

The process and the apparatus according to the invention offer advantages, particularly as far as multicolour printing by the flexographic process is concerned.

It should be added that from the Belgian Patent Publication 704 303 a different process of making printing forms is known. In that process, however, during centrifugal casting a kind of matrix is placed in the moulding material instead of an image-bearing film, as a result of which the quality of the printing form to be made is unfavourably influenced. Moreover, the manufacture of such matrices is relatively costly and laborious.

Mention should also be made of the Belgian Patent Publication 600 961, which relates to a method for manufacturing forms for a different process, viz. rotogravure printing. In that known method first a cylinder is made by centrifugal casting a moulding material melted by heating. This cylinder is then photosensitized by subjecting it to a treatment with an aqueous solution of potassium bichromate.

Other patent publications to be mentioned are: CA 612 917, DE 1 522 359, NL 182 736, U.S. 3 257 944, U.S. 3 496 606, JP 43 702/74 (examined by the Patent Office), GB 1 045 674 and GB 1 114 704. All these patent publications describe one or more elements of the process according to the invention. So far, however, the processes according to these patent publications have not led to such a practicable process for the manufacture of printing forms for use in flexographic printing as will satisfy very high requirements as far as quality, accuracy and efficiency are concerned.

Within the scope of the invention various modifications may be made.

## Claims

1. A process for the manufacture of a cylindrical relief printing form from a liquid photopolymerizable moulding material, wherein an image-bearing film is placed against the inner surface of a transparent cylindrical tube, the moulding material is spread over the film by centrifugal force, the material is then irradiated via the film by ultraviolet radiation sources distributed around the circumference of the cylinder and directly by one or more ultra-violet radiation sources within the tube while the tube is rotated, to prepolymerize the material and harden it at exposed areas thereof, the pre-polymerized printing from is removed from the tube and washed to remove non-hardened moulding material at unexposed areas thereof, and the pre-polymerized printing form is exposed all round to radiation for post-curing.

2. A process according to claim 1, characterized in that as transparent cylinder there is used a glass circular cylinder.

3. A process according to claim 2, characterized in that the transparent cylinder is so machined internally that both in radial and in axial direction it does not deviate more than plus or minus 0,10 mm from the desired form relative to the axis of rotation thereof.

4. A process according to claim 3, characterized in that said deviation is not more than plus or minus 0,02 mm.

5. A process according to claim 3, characterized in that use is made of a transparent circular-cylindrical tube having an internal diameter in the range of 100 to 600 mm, a wall thickness of 5 to 20 mm and a length of 200 to 1000 mm.

6. A process according to one or more of the preceding claims, characterized in that the image-bearing film is placed on the inside wall of the transparent cylinder by applying a vacuum.

7. A process according to one or more of the preceding claims, characterized in that use is made of an image-bearing film which on the side of the glass wall is previously provided with a thin adhesive coating.

8. A process according to claim 7, characterized in that use is made of an adhesive coating which does not become active until some influence, such as that of surface pressure, heating or radiation, is exerted on the image-bearing film.

9. A process according to one or more of the preceding claims, characterized in that prior to the liquid moulding material being introduced the image-bearing film is on the radially inward side provided with a cover film.

10. An apparatus for carrying out the process according to one or more of the claims 1—9, formed by a framework provided with radiation sources for hardening photopolymerizable moulding material comprising a rotatable transparent horizontally mounted hollow cylinder (2) capable of retaining a charge of liquid photopolymerizable liquid, drive means (5, 6) for rotating the cylinder sufficiently fast to spread the liquid over the internal surface by centrifugal force, covers (15, 16) at the ends of the hollow cylinder for retaining the liquid in the cylinder, ultraviolet radiation sources inside (11) and outside (9) the cylinder and means (7) for introducing the liquid into the cylinder.

11. An apparatus according to claim 10, characterized in that one or more radiation sources are mounted axially moveable relative to the axis of the transparent cylinder in such a way that said radiation sources can be displaced from the outside to the inside of the rotatable transparent cylinder.

12. An apparatus according to claim 10, characterized in that both in radial and in axial direction the internal cylindrical surface of the transparent cylinder does not deviate more than plus or minus 0,10 mm from the desired cylindrical form relative to the axis of rotation.

13. An apparatus according to claim 12, characterized in that said deviation is not more than plus or minus 0,02 mm.

14. An apparatus according to one or more of the claims 10—13, characterized in that the transparent cylindrical tube has an internal diameter of 100 to 600 mm, a wall thickness of 5 to 20 mm and an axial length of 200 to 1000 mm.

15. An apparatus according to one or more of the claims 10—14, characterized in that the internal surface of the cylindrical tube is provided with one or more axial and/or radial grooves for permitting the escape of air.

## Revendications

1. Un procédé pour la fabrication d'une forme d'impression en relief cylindrique à partir d'une matière de moulage liquide photopolymérisable, dans lequel une pellicule support d'image est placée contre la surface interne d'un tube cylindrique transparent, la matière de moulage est étalée sur la pellicule par la force centrifuge, la matière est ensuite irradiée à travers la pellicule par des sources de rayonnement ultraviolet réparties autour de la circonférence du cylindre et directement par une ou plusieurs sources de rayonnement ultraviolet disposées à l'intérieur du tube pendant que le tube est entraîné en rotation, pour prépolymériser la matière et la durcir dans ses régions exposées, la forme d'impression prépolymérisée est retirée du tube et lavée pour enlever la matière de moulage non durcie dans ses régions non exposées, et la forme d'impression prépolymérisée est exposée tout autour à un rayonnement pour réaliser un post-durcissement.

2. Un procédé selon la revendication 1, caractérisé en ce qu'on utilise en tant que cylindre transparent un cylindre circulaire de verre.

3. Un procédé selon la revendication 2, caractérisé en ce que le cylindre de verre est usiné intérieurement de telle sorte qu'aussi bien en direction radiale qu'axiale, il ne s'écarte pas plus de plus ou moins 0,10 mm de la forme désirée par rapport à son axe de rotation.

4. Un procédé selon la revendication 3, caractérisé en ce que ledit écart n'est pas supérieur à plus ou moins 0,02 mm.

5. Un procédé selon la revendication 3, caractérisé en ce qu'on utilise un tube cylindrique circulaire transparent ayant un diamètre intérieur compris entre 100 et 600 mm, une épaisseur de paroi de 5 à 20 mm et une longueur de 200 à 1000 mm.

6. Un procédé selon une ou plusieurs des revendications précédentes caractérisé en ce que la pellicule support d'image est placée sur la paroi intérieure du cylindre transparent par application d'un vide.

7. Un procédé selon une ou plusieurs des revendications précédentes, caractérisé en ce qu'on utilise une pellicule support d'image qui a été préalablement munie, du côté de la paroi de verre, d'un mince revêtement adhésif.

8. Un procédé selon la revendication 7, caractérisé en ce qu'on utilise un revêtement adhésif qui ne devient pas actif tant qu'une certaine influence, telle qu'une pression superficielle, un chauffage ou un rayonnement, n'est pas exercée sur la pellicule support d'image.

9. Un procédé selon une ou plusieurs des revendications précédentes, caractérisé en ce qu'avant l'introduction de la matière de moulage liquide, la pellicule support d'image est munie, sur son côté radialement intérieur, d'une pellicule de couverture.

10. Un appareil pour la mise en oeuvre du procédé selon une ou plusieurs des revendications 1—9, formé par un châssis muni de sources de rayonnement pour durcir une matière de moulage photopolymérisable comprenant un cylindre creux transparent rotatif (2) monté horizontalement, capable de retenir une charge de liquide photopolymérisable liquide, des moyens d'entraînement (5, 6) pour faire tourner le cylindre suffisamment rapidement pour étaler le liquide sur la surface interne par force centrifuge, des couvercles (15, 16) aux extrémités du cylindre, des sources de rayonnement ultraviolet disposées à l'intérieur (11) et à l'extérieur (9) du cylindre et des moyens (7) pour introduire le liquide dans le cylindre.

11. Un appareil selon la revendication 10, caractérisé en ce qu'une ou plusieurs sources de rayonnement sont montées axialement mobiles par rapport à l'axe du cylindre transparent d'une manière telle que lesdites sources de rayonnement peuvent être déplacées de l'extérieur jusqu'à l'intérieur du cylindre rotatif transparent.

12. Un appareil selon la revendication 10, caractérisé en ce que, tant en direction radiale qu'axiale, la surface cylindrique interne du cylindre transparent ne s'écarte pas plus de plus ou moins 0,10 mm de la forme cylindrique désirée par rapport à l'axe de rotation.

13. Un appareil selon la revendication 12, caractérisé en ce que ledit écart n'est pas supérieur à plus ou moins 0,02 mm.

14. Un appareil selon une ou plusieurs des revendications 10 à 13, caractérisé en ce que le tube cylindrique transparent a un diamètre intérieur de 100 à 600 mm, une épaisseur de paroi de 5 à 20 mm et une longueur axiale de 200 à 1000 mm.

15. Un appareil selon une ou plusieurs des revendications 10 à 14, caractérisé en ce que la surface interne du tube cylindrique est munie d'une ou plusieurs rainures axiales et/ou radiales pour permettre l'échappement de l'air.

**Patentansprüche**

1. Verfahren zur Herstellung einer zylindrischen Hochdruckform aus einem flüssigen photopolymerisierbaren Gießmaterial, bei welchem ein ein Bild tragender Film auf der Innenseite einer transparenten zylindrischen Röhre angeordnet wird, das Gießmaterial über den Film mittels Zentrifugalkraft verteilt und sodann durch den Film von über den Zylinderumfang verteilten ultravioletten Strahlenquellen sowie unmittelbar von einer oder mehreren ultravioletten Strahlenquellen innerhalb der Röhre während deren Drehung bestrahlt wird, um das Material vorzupolymerisieren und an dessen exponierten Bereichen zu härten, worauf die vorpolymerisierte Druckform von der Röhre abgenommen und gewaschen wird, um an nicht exponierten Bereichen ungehärtetes Gießmaterial zu entfernen, und die vorpolymerisierte Druckform zum Nachhärten rundum der Strahlung ausgesetzt wird.

2. Verfahren nach Anspruch 1, dadurch gekennzeichnet, daß als transparenter Zylinder ein Kreiszylinder aus Glas verwendet wird.

3. Verfahren nach Anspruch 2, dadurch gekennzeichnet, daß der transparente Zylinder innen derart bearbeitet wird, daß er sowohl in radialer als auch in axialer Richtung nicht mehr als ±0,10 mm von der Sollform bezüglich seiner Drehachse abweicht.

4. Verfahren nach Anspruch 3, dadurch gekennzeichnet, daß die Abweichung nicht mehr als ±0,02 mm beträgt.

5. Verfahren nach Anspruch 3, dadurch gekennzeichnet, daß ein transparentes kreiszylindrisches Rohr mit einem Innendurchmesser im Bereich von 100 bis 600 mm, einer Wandstärke von 5 bis 20 mm und einer Länge von 200 bis 1000 mm verwendet wird.

6. Verfahren nach einem der Ansprüche 1 bis 5, dadurch gekennzeichnet, daß der bildtragende Film auf der Innenwand des transparenten Zylinders durch Ausübung eines Unterdruckes angeordnet wird.

7. Verfahren nach einem der Ansprüche 1 bis 6, dadurch gekennzeichnet, daß ein bildtragender Film verwendet wird, der an der Seite der Glaswand vorher mit einer dünnen Klebeschicht versehen worden ist.

8. Verfahren nach Anspruch 7, dadurch gekennzeichnet, daß eine Klebeschicht verwendet wird, die nicht aktiv wird, bis ein Einfluß, wie derjenige eines Oberflächendruckes, einer Erwärmung oder Bestrahlung auf den bildtragenden Film ausgeübt wird.

9. Verfahren nach einem der Ansprüche 1 bis 8, daduch gekennzeichnet, daß vor dem Einbringen des flüssigen Gießmateriales der bildtragende Film an der radial innenliegenden Seite mit einem Überzugsfilm versehen wird.

10. Vorrichtung zur Durchführung des Verfahrens nach einem der Ansprüche 1 bis 9, die von einem mit Strahlenquellen zum Härten eines photopolymerisierbaren Gießmateriales versehenen Gestell gebildet ist, bestehend aus einem drehbaren transparenten horizontal angebrachten hohlen Zylinder (2), der zur Aufnahme einer Menge flüssiger photopolymerisierbarer Flüssigkeit ausgebildet ist, einer Antriebsvorrichtung (5, 6) zur Drehung des Zylinders mit zur Verteilung der Flüssigkeit über die Innenseite durch Zentrifugalkraft ausreichender Geschwindigkeit, aus Deckeln (15, 16) an den Enden des hohlen Zylinders zum Zurückhalten der Flüssigkeit im Zylinder, aus ultravioletten Strahlenquellen innerhalb (11) und außerhalb (9) des Zylinders und aus einer Einrichtung (7) zum Einbringen der Flüssigkeit in den Zylinder.

11. Vorrichtung nach Anspruch 10, dadurch gekennzeichnet, daß eine oder mehrere Strahlenquellen bezüglich der Achse des transparenten Zylinders in solcher Weise axial beweglich montiert sind, daß diese Strahlenquellen von der Außenseite zur Innenseite des drehbaren transparenten Zylinders verlagert werden können.

12. Verfahren nach Anspruch 10, dadurch gekennzeichnet, daß sowohl in radialer als auch in axialer Richtung die innere Zylinderfläche des transparenten Zylinders nicht mehr als ±0,10 mm von der zylindrischen Sollform bezüglich der Drehachse abweicht.

13. Vorrichtung nach Anspruch 12, dadurch gekennzeichnet, daß die Abweichung nicht mehr als ±0,02 mm beträgt.

14. Vorrichtung nach einem der Ansprüche 10 bis 13, dadurch gekennzeichnet, daß die transparente zylindrische Röhre einen Innendurchmesser von 100 bis 600 mm, eine Wandstärke von 5 bis 20 mm und eine axiale Länge von 200 bis 1000 mm hat.

15. Vorrichtung nach einem der Ansprüche 10 bis 14, dadurch gekennzeichnet, daß die Innenseite der zylindrischen Röhre mit einer oder mehreren axialen und/oder radialen Rillen zur Abfuhr von Luft versehen ist.

## fig.1

0 007 127

# fig.2

2